# EUROPÄISCHE PATENTSCHRIFT

(11) **EP 0 494 153 B1**
(45) Veröffentlichungstag und Bekanntmachung des Hinweises auf die Patenterteilung: **09.11.1994**
(21) Anmeldenummer: 90912159.2
(22) Anmeldetag: 24.08.1990
(51) Int. Cl.: H05K 7/20

(54) **VERBUNDANORDNUNG MIT LEITERPLATTE**
COMPOUND ARRANGEMENT WITH PRINTED CIRCUIT BOARD
AGENCEMENT COMPOSITE AVEC CARTE DE CIRCUITS IMPRIMES

(30) Priorität: 27.09.1989 DE 3932213
(43) Veröffentlichungstag der Anmeldung: 15.07.1992
(73) Patentinhaber: ROBERT BOSCH GMBH, 70442 Stuttgart (DE)
(72) Erfinder: RÖTHLINGSHÖFER, Walter, D-7410 Reutlingen (DE); GOEBEL, Ulrich, D-7410 Reutlingen (DE); GERSTNER, Roland, D-7410 Reutlingen 3 (DE)
(86) Internationale Anmeldenummer: DE9000646
(87) Internationale Veröffentlichungsnummer: WO9105455

(56) Entgegenhaltungen:
- EP-A- 232 098
- GB-A- 2 135 521
- US-A- 4 383 270
- US-A- 4 546 410

## Beschreibung

### Stand der Technik

Die Erfindung betrifft eine Verbundanordnung mit Leiterplatte gemäß der Gattung des Hauptanspruchs.

Um die von elektrischen Bauelementen auf einer Leiterplatte abgegebene Verlustleistung möglichst gut abführen zu können, werden Leiterplatten mittels eines geeigneten Klebers auf einem Kühlkörper flächig aufgeklebt. Die Leiterplatten können dabei aus einem Keramiksubstrat bestehen und eine Fläche von beispielsweise 6 x 4 Zoll aufweisen. Der unter der Leiterplatte befindliche Kühlkörper kann aus einer Aluminiumplatte oder dergleichen bestehen, der an die Fläche der aufgeklebten keramischen Leiterplatte angepaßt ist.

Bei diesen Verbundanordnungen besteht einerseits die Forderung, daß der Kleber ausreichend elastisch sein muß, damit er aufgrund seiner Elastizität die unterschiedlichen Wärmeausdehnungen von Keramiksubstrat und Aluminiumplatte ausgleichen kann. Andererseits sollte der Kleber jedoch eine möglichst gute Wärmeleitfähigkeit besitzen, damit die von den Bauelementen abgegebene Wärme (Verlustleistung) möglichst gut zur Aluminiumplatte abgeleitet werden kann, damit sich die entsprechenden elektrischen Bauelemente nicht zu stark erwärmen. Um dem Kleber bessere Wärmeableitfähigkeit zu verleihen, können in ihn z.B. Metallpartikel, keramische Partikel oder andere Stoffe mit hoher Wärmeleitfähigkeit eingebracht werden. Die Elastizität des Klebers wird jedoch um so stärker verringert, je mehr wärmeleitfähige Partikel im Kleber vorhanden sind. Dies hat zur Folge, daß die Klebeschicht dicker ausgebildet sein muß als bei einem hochelastischen Kleber, welcher jedoch eine sehr schlechte Wärmeleitfähigkeit aufweist. Die dickeren Klebeschichten bei gefüllten Klebern wirken jedoch wiederum einer guten Wärmeableitung entgegen. Außerdem haben die mit wärmeleitfähigen Partikeln angereicherten Kleber eine merklich schlechtere Klebeeigenschaft als die Kleber, die nicht "gefüllt" sind.

### Vorteile der Erfindung

Eine Verbundanordnung mit den Merkmalen des Hauptanspruchs hat demgegenüber den Vorteil, daß genau dort, wo hohe Verlustleistung und Wärme auftritt über die in diesem Bereich angeordnete Wärmeleitpaste eine optimale Wärmeableitung zum Kühlkörper gewährleistet ist. Die übrigen Bereiche, in denen keine nennenswerte Erwärmung auftritt, sind über eine hochelastische Klebeschicht mit der als Kühlkörper dienenden Grundplatte verbunden, wobei eine dünne Schicht des hochelastischen Klebers ausreicht, um den unterschiedlichen Wärmeausdehnungskoeffizienten von Leiterplatte und Grundplatte Rechnung zu tragen. Der elastische Kleber besitzt gute Klebeeigenschaften, so daß auch eine sehr gute mechanische Verbindung zwischen Leiterplatte und Grundplatte besteht. Die dünne Klebeschicht hat weiterhin zur Folge, daß auch die Inseln mit Wärmeleitpaste eine entsprechend geringe Schichtdicke aufweisen und somit die Wärmeableitung im Bereich der verlustleistungsbehafteten Bauelemente zum darunter befindlichen Kühlkörper begünstigen.

Die Inseln bestehen vorzugsweise aus Wärmeleitpaste, jedoch kann für besondere Anwendungsfälle auch ein anderes Material Verwendung finden. Beispielsweise könnte ein mit wärmeleitfähigen Partikeln angereicherter Kleber, dessen Wärmeableitfähigkeit wesentlich höher ist als die der übrigen Klebeschicht, Verwendung finden.

Die Anordnung von Inseln mit hoher Wärmeleitfähigkeit ist besonders vorteilhaft in Verbindung mit Dickschichtschaltungen auf Keramiksubstrat, welches auf einen metallischen Kühlkörper aufgeklebt ist. Die sehr unterschiedlichen Wärmeausdehnungskoeffizienten des Keramiksubstrats und beispielsweise eines Aluminiumkühlkörpers lassen sich durch die erfindungsgemäße Ausbildung der Zwischenschicht sehr gut berücksichtigen.

Insbesondere bei großformatigen Verbundanordnungen kann es sehr vorteilhaft sein, zwischen Leiterplatte und Grundplatte Abstandselemente über die Fläche verteilt anzuordnen. Als Abstandselemente können hierbei Klebepunkte, Glaskugeln oder dergleichen Verwendung finden. Die Abstandselemente haben den Vorteil, daß während des Klebevorgangs die Leiterplatte unter Druck niedergehalten werden kann und dabei ein einheitlicher Abstand zwischen Leiterplatte und Grundplatte gewährleistet wird. Auf diese Weise erhält man definierte Verhältnisse, d.h. daß die Zwischenschicht über die gesamte Fläche eine einheitliche Dicke hat.

Zur Herstellung der Verbundanordnung kann die Klebeschicht mit ihren inselförmigen Aussparungen im Siebdruckverfahren oder im Pin-Transferverfahren aufgebracht werden. Das Pin-Transferverfahren verwendet eine Vielzahl von dicht nebeneinander angeordneten Transfernadeln, die für den Transfervorgang zunächst in den Kleber eingetaucht werden und dann auf den Flächen der Grundplatte aufgesetzt werden, wo Kleber aufgetragen werden soll.

### Zeichnung

Die Erfindung wird nachfolgend anhand der Zeichnung näher erläutert. Es zeigen:
Figur 1 eine Verbundanordnung im Längsschnitt entlang der Schnittlinie AB gemäß Figur 2 und
Figur 2 die Draufsicht der in Figur 1 dargestellten Verbundanordnung.

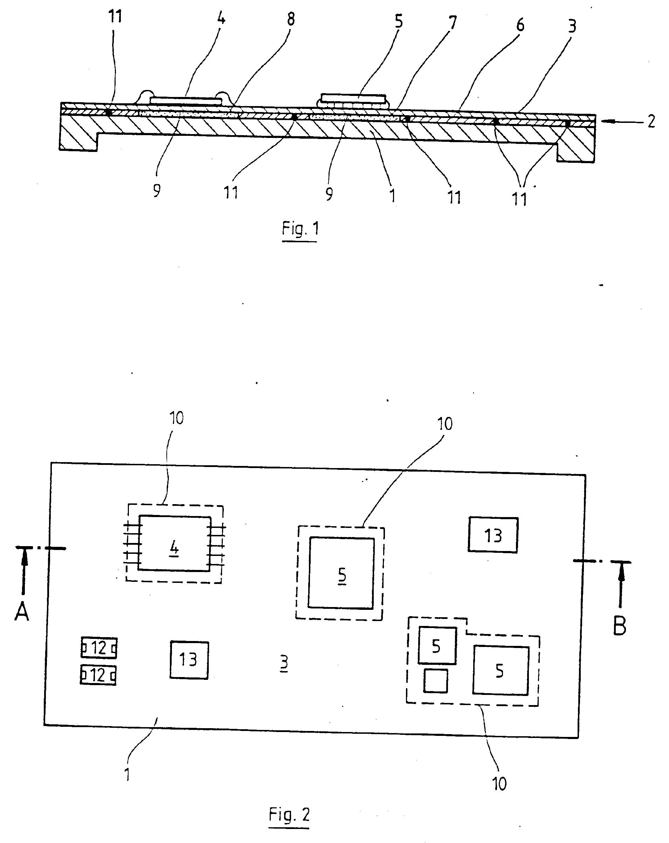

Die in Figur 1 dargestellte Verbundanordnung besteht aus einer als Kühlkörper dienenden Grundplatte 1, einer Zwischenschicht 2 und einer Leiterplatte 3, an deren Oberseite elektrische Bauelemente 4, 5 mit hoher Verlustleistung sowie Bauelemente 12, 13 ohne große Verlustleistung angeordnet sind. Die Grundplatte 1 besteht im Ausführungsbeispiel aus Aluminium, während die Leiterplatte 3 ein Keramiksubstrat ist. Auf der Oberseite des Keramiksubstrats sind hier nicht sichtbare Leiterbahnen aufgebracht, die die Bauelemente 4, 5, 12, 13 elektrisch verbinden.

Die Zwischenschicht 2 besteht aus einer Klebeschicht 6 und Inseln 7, 8 aus Wärmeleitpaste 9.

Die Fläche der Inseln 7, 8 ist in Figur 2 mit unterbrochenen Linien 10 eingezeichnet. Dabei wird deutlich, daß die Fläche der Inseln 7, 8 größer ausgebildet ist, als die Fläche der darüber befindlichen Bauelemente 4, 5. Die etwas vergrößerte Fläche der Inseln 7, 8 bewirkt eine Verbesserung der Wärmeableitung zur Grundplatte 1.

Die Bauelemente können in beliebiger Montagetechnik als verpackte oder unverpackte Bauform auf der Leiterplatte befestigt werden, z.B. chip-and-wire, PLCC, TO, Flip Chip usw..

Die Leiterplatte 3 kann während des Aushärtens der Klebeschicht 6 (Figur 1) auf die Klebeschicht 6 gedrückt werden. In der Klebeschicht befinden sich über die Fläche verteilt angeordnete Abstandselemente 11, die als zuvor aufgebrachte und ausgehärtete Klebepunkte ausgebildet sind. Es können hierfür jedoch auch entsprechend kleine Glaskugeln oder dergleichen Abstandselemente Verwendung finden. Durch das Niederdrücken der Leiterplatte 3 auf die Abstandselemente 11 wird gewährleistet, daß die Zwischenschicht 2 über die gesamte Fläche eine einheitliche Dicke erhält.

## Patentansprüche

1. Verbundanordnung mit Leiterplatte, bei der die Leiterplatte auf einer als Kühlkörper dienenden Grundplatte aufgeklebt ist, wobei die Grundplatte einen anderen Wärmeausdehnungskoeffizienten aufweist als die Leiterplatte, an deren freier Oberseite ein oder mehrere verlustleistungsbehaftete elektrische Bauelemente angeordnet sind, dadurch gekennzeichnet, daß in den Bereichen der zwischen Leiterplatte (3) und Grundplatte (1) befindlichen Klebeschicht (6), über denen verlustleistungsbehaftete elektrische Bauelemente (4, 5) angeordnet sind, Inseln (7, 8) mit erhöhter Wärmeleitfähigkeit zwischen Leiterplatte (3) und Grundplatte (1) ausgebildet sind.

2. Verbundanordnung nach Anspruch 1, dadurch gekennzeichnet, daß die Inseln (7, 8) aus Wärmeleitpaste (9) bestehen.

3. Verbundanordnung nach einem der Ansprüche 1 oder 2, dadurch gekennzeichnet, daß die Leiterplatte (3) aus einem Keramiksubstrat mit elektrisch leitenden und/oder isolierenden Strukturen und die Grundplatte (1) aus Aluminium bestehen und über eine hochelastische Klebeschicht (6) mechanisch verbunden sind.

4. Verbundanordnung nach einem der vorhergehenden Ansprüche, dadurch gekennzeichnet, daß die Leiterplatte (3) als Keramiksubstrat mit einer Dickschichtschaltung ausgebildet ist, auf der verpackte oder unverpackte Halbleiter als Bauelemente (4, 5) aufgeklebt sind.

5. Verbundanordnung nach einem der vorhergehenden Ansprüche, dadurch gekennzeichnet, daß zwischen Leiterplatte (3) und Grundplatte (1) Abstandselemente (11) über die Fläche verteilt angeordnet sind.

6. Verbundanordnung nach Anspruch 5, dadurch gekennzeichnet, daß die Abstandselemente (11) als ausgehärtete Klebepunkte aufgebracht sind.

7. Verfahren zur Herstellung einer Verbundanordnung nach einem der vorhergehenden Ansprüche, dadurch gekennzeichnet, daß zunächst auf die Grundplatte (1) oder die Leiterplatte (3) Abstandselemente (11) aufgebracht werden, daß dann eine Klebeschicht (6) augebracht wird, die klebefreie Inseln (7, 8) aufweist, daß in die ausgesparten Inseln (7, 8) Wärmeleitpaste (9) eingebracht wird, und daß dann die Leiterplatte (3) auf die Klebeschicht (6) aufgedrückt und unter Druck der Kleber ausgehärtet wird.

8. Verfahren nach Anspruch 7, dadurch gekennzeichnet, daß Kleber und/oder Wärmeleitpaste (9) im Siebdruckverfahren oder mittels Pin-Transfer auf die Grundplatte (1) aufgebracht werden.

## Claims

1. Composite arrangement comprising a printed circuit board, in which the printed circuit board is bonded onto a base plate serving as heat sink, the base plate having a coefficient of thermal expansion which is different from that of the printed circuit board, on whose free upper side one or more electrical components which are subject to power loss are disposed, characterized in that islands (7, 8) having increased thermal conductivity are formed between printed circuit board (3) and base plate (1) in those regions of the adhesive layer (6) which are situated between printed circuit board (3) and base plate (1) and above which electrical components (4, 5) which are subject to power loss are disposed.

2. Composite arrangement according to Claim 1, characterized in that the islands (7, 8) are composed of heat-conducting paste (9).

3. Composite arrangement according to either of Claims 1 or 2, characterized in that the printed circuit board (3) is composed of a ceramic substrate having electrically conducting and/or insulating structures and the base plate (1) is composed of aluminium and they are joined mechanically by means of a highly elastic adhesive layer (6).

4. Composite arrangement according to one of the preceding claims, characterized in that the printed circuit board (3) is formed as a ceramic substrate with a thick-film circuit on which packaged or unpackaged semiconductors are bonded as components (4, 5).

5. Composite arrangement according to one of the preceding claims, characterized in that spacer elements (11) are disposed between printed circuit board (3) and base plate (1) so as to be distributed over the area.

6. Composite arrangement according to Claim 5, characterized in that the spacer elements (11) are applied as cured adhesion points.

7. Method of producing a composite arrangement according to one of the preceding claims, characterized in that spacer elements (11) are first applied to the base plate (1) or the printed circuit board (3), in that an adhesive layer (6) which has adhesive-free islands (7, 8) is then applied, in that heat-conducting paste (9) is introduced into the cut-out islands (7, 8), and in that the printed circuit board (3) is then pressed onto the adhesive layer (6) and the adhesive is cured under pressure.

8. Method according to Claim 7, characterized in that adhesive and/or heat-conducting paste (9) is applied to the base plate (1) by the screen-printing method or by means of pin transfer.

## Revendications

1. Agencement composite avec une carte de circuits imprimés, dans lequel la carte de circuits imprimés est collée sur une plaque de base jouant le rôle de dissipateur de chaleur, tandis que la plaque de base a une coefficient de dilatation thermique différent de celui de la carte de circuits imprimés, sur la surface libre de laquelle sont disposés un ou plusieurs composants électriques affectés d'une puissance de perte, caractérisé en ce que, dans les zones de la couche de colle (6) se trouvant entre la carte de circuits imprimés (3) et la plaque de base (1), sur lesquelles sont disposés des composants électriques (4, 5) affectés d'une puissance de perte, il est prévu des îlots (7, 8) avec une conductibilité thermique plus élevée entre la carte de circuits imprimés (3) et la plaque de base (1).

2. Agencement composite selon la revendication 1, caractérisé en ce que les îlots (7, 8) sont constitués par une pâte conductrice de la chaleur (9).

3. Agencement composite selon une des revendications 1 ou 2, caractérisé en ce que la carte de circuits imprimés (3) est constituée par un substrat en céramique avec des structures électriquement conductrices et/ou des structures isolantes, tandis que la plaque de base (1) est constituée d'aluminium, la carte de circuits imprimés et la plaque de base sont reliées mécaniquement par l'intermédiaire d'une couche de colle d'une élasticité élevée.

4. Agencement composite selon une des précédentes revendications, caractérisé en ce que la carte de circuits imprimés (3) est réalisée sous la forme d'un substrat en céramique avec un circuit en couches épaisses, sur lequel sont collés en tant que composants (4, 5) des semiconducteurs conditionnés ou non.

5. Agencement composite selon une des précédentes revendications, caractérisé en ce que, entre la carte de circuits imprimés (3) et la plaque de base (1), sont disposés des éléments d'espacement (11) répartis sur la surface.

6. Agencement composite selon la revendication 5, caractérisé en ce que les éléments d'espacement (11) sont appliqués sous la forme de points de colle durcis.

7. Procédé pour la fabrication d'un agencement composite selon une des précédentes revendications, procédé caractérisé en ce que tout d'abord, des éléments d'espacement (11) sont rapportés sur la plaque de base (1) ou la carte de circuits imprimés (3), en ce qu'ensuite est appliquée une couche de colle (6), qui comporte des îlots (7, 8) exempts de colle, en ce que dans les îlots (7, 8) ainsi ménagés, est appliquée une pâte conductrice de la chaleur (9), et en ce qu'ensuite la carte de circuits imprimés (3) est pressée sur la couche de colle (6) et la colle est durcie sous pression.

8. Procédé selon la revendication 7, caractérisé en ce que la colle et/ou la pâte conductrice de la chaleur (9) est rapportée sur la plaque de base (1) selon le procédé de sérigraphie ou par pin-transfert.
